# EUROPÄISCHE PATENTSCHRIFT

(11) **EP 3 539 165 B1**
(45) Veröffentlichungstag und Bekanntmachung des Hinweises auf die Patenterteilung: **10.03.2021**
(21) Anmeldenummer: 17803842.8
(22) Anmeldetag: 10.11.2017
(51) Int. Cl.: H01L 41/053, H01L 41/09

(54) **PIEZOELEKTRISCHER BIEGEAKTORANTRIEB FÜR EINSATZ IN FEUCHTER UMGEBUNG**
PIEZOELECTRIC BENDING ACTUATOR DRIVE FOR USE IN A MOIST ENVIRONMENT
ENTRAÎNEMENT D'ACTIONNEUR DE FLEXION PIÉZOÉLECTRIQUE POUR UTILISATION DANS UN MILIEU HUMIDE

(30) Priorität: 10.11.2016 DE 102016121587
(43) Veröffentlichungstag der Anmeldung: 18.09.2019
(73) Patentinhaber: PI Ceramic GmbH, 07589 Lederhose (DE)
(72) Erfinder: DARGATZ, Benjamin, 07745 Jena (DE); SPEER, Kevin, 07646 Mörsdorf (DE); BROICH, Bernd, 07570 Weida (DE)
(74) Vertreter: Grünecker Patent- und Rechtsanwälte PartG mbB
(86) Internationale Anmeldenummer: PCT/EP2017/078958
(87) Internationale Veröffentlichungsnummer: WO 2018/087333

(56) Entgegenhaltungen:
- WO-A1-99/65088
- WO-A1-2016/094416
- DE-A1- 2 848 812
- US-A1- 2006 138 903

## Beschreibung

Die vorliegende Erfindung betrifft einen piezoelektrischen Antrieb, insbesondere für den Einsatz in feuchter Umgebung, bzw. einen piezoelektrischen Aktor für den Einsatz in einer Umgebung, welche Feuchtigkeit oder andere korrosive Fluide enthält und insbesondere eine Bewegung von oder gegen andere Objekte ausführt.

Üblicherweise sind piezoelektrische Materialien in feuchter Umgebung, z. B. einem elektrolytischen Fluid, Wasser, Kraftstoff oder in Luft mit hoher Luftfeuchtigkeit und Kondensation, hermetisch versiegelt, um Korrosion und chemische Einwirkung durch ein Fluid an metallischem oder piezokeramischem Material zu vermeiden, weil Korrosion üblicherweise zu einem Versagen der Isolation der piezoelektrischen Schichten führt, wenn Fremdmaterial wie Feuchtigkeit und elektrisch leitfähige Partikel an den Folienelektroden und dem piezoelektrischen Material abgelagert werden. Durch eine Beschichtung des piezoelektrischen Antriebs selbst kann Korrosion nicht vollständig vermieden werden.

Piezoelektrische Aktoren oder Antriebe für den Einsatz in feuchter Umgebung, wie z. B. Ventile oder Pumpvorrichtungen zur Förderung von Fluid sind aus den Patentdokumenten US 4,553,059 A, EP 1 158 182 A1, US 3,963,380 A, DE 698 21 969 T2 oder US 5,205,819 A bekannt.

Die US 4,553,059 A offenbart einen weiteren piezoelektrischen Antrieb. Der Korrosionsschutz wird in diesem Fall dadurch bewerkstelligt, dass eine stapelartige piezoelektrische Antriebseinheit in einem Silikonöl angeordnet ist, welches als hydraulisches Element dient. Dieser aus dem Stand der Technik bekannte, piezoelektrische Antrieb weist allerdings einen komplexen Aufbau auf und erfordert einen erheblichen Bauraum, insbesondere in der Wirkungsrichtung des piezoelektrischen Antriebs.

Weitere piezoelektrische Antriebe sind der WO 99/65 088 A1 und der DE 28 48 812 bekannt.

WO 2016/094416 A1 beschreibt eine Anordnung mit je einem piezoelektrischen Biegeaktor in je einer durch eine elastische Membran aus Silizium oder eventuell auch Metall hermetisch abgeschlossenen Vakuumkammer.

US 2006/138903 A1 offenbart einen piezoelektrischen Antrieb für den Einsatz in feuchter Umgebung, umfassend ein Gehäuse mit einer Kammer, die durch elastische Membranen hermetisch verschlossen ist, wobei ein piezoelektrischer Biegeaktor freiliegend in der Kammer angeordnet. Gehäuse und Membran sind aus Polymermaterial und etwa durch Kleben miteinander verbunden.

Der vorliegenden Erfindung liegt die Aufgabe zu Grunde, einen kompakten und stabilen piezoelektrischen Antrieb, insbesondere für den Einsatz in feuchter Umgebung bereitzustellen, wobei ein dauerhafter Schutz der piezoelektrischen Antriebseinheit vor Fremdmaterial wie Feuchtigkeit und elektrisch leitfähigen Partikeln erzielt werden kann.

Zur Lösung dieser Aufgabe stellt die Erfindung den piezoelektrischen Antrieb nach Anspruch 1 bereit. Der erfindungsgemäße piezoelektrische Antrieb ist insbesondere für den Einsatz in feuchter Umgebung vorgesehen und umfasst folgende Merkmale: Ein Gehäuse aus Metall mit einer Kammer, die durch eine elastische Membran aus Metall hermetisch verschlossen ist, wobei die Membran durch Löten oder Schweißen mit dem Gehäuse verbunden ist, wobei eine piezoelektrische Antriebseinheit in der hermetisch verschlossenen Kammer angeordnet und zum Antrieb eines Antriebselements durch elektrische Ansteuerung piezoelektrisch verformbar ist, wobei die piezoelektrische Antriebseinheit wenigstens einen piezoelektrischen Biegeaktor aufweist, der bei elektrischer Ansteuerung eine Biegeauslenkung quer zu der elastischen Membran erzeugt. Die Antriebseinheit des erfindungsgemäßen Antriebs ist im Vergleich zu dem herkömmlichen Antrieb wesentlich kompakter aufgebaut und erfordert eine deutlich geringere Bauhöhe, insbesondere in der Wirkungsrichtung des piezoelektrischen Antriebs. Bei diesem Aufbau ist die piezoelektrische Antriebseinheit dauerhaft und sicher vor dem Kontakt mit Fremdmaterial wie Feuchtigkeit und elektrisch leitfähigen Partikeln geschützt, während die Antriebswirkung durch die elastische Membran auf ein vorzugsweise außerhalb der hermetisch verschlossenen Kammer angeordnetes Antriebselement leicht übertragen werden kann. Der piezoelektrische Antrieb ist wahlweise mit dem Antriebselement gekoppelt oder koppelbar. Das Antriebselement kann demnach einen Bestandteil des Antriebs darstellen oder ein ergänzendes bzw. gesondertes Bauteil. "Quer" zu der elastischen Membran soll bedeuten, dass die Richtung der Biegeauslenkung, die Richtung des Arbeitshubs oder die Richtung der Antriebskraft der piezoelektrischen Antriebseinheit die Membran schneidet, d.h. mit der (unverformten) Membran einen Winkel zwischen 0 und 180°, vorzugsweise im Bereich von 45 bis 135°, bevorzugt 90° einschließt. Wenngleich es bevorzugt ist, dass die Membran bei Biegeauslenkung des Biegeaktors (zeitgleich) verformt wird, so ist dies nicht zwingend erforderlich. Es ist möglich, dass die piezoelektrische Antriebseinheit bei Biegeauslenkung des Biegeaktors nicht mit der elastischen Membran in Kontakt gelangt, z. B. wenn die Antriebseinheit von dem Antriebselement entkoppelt ist. Die Kopplung der Antriebseinheit (z.B. innerhalb der Kammer) mit dem Antriebselement (z.B. außerhalb der Kammer) kann dann z. B. unter elastischer Verformung der Membran erfolgen, sodass das Antriebselement in den Wirkbereich des piezoelektrischen Antriebs gelangt und bei elektrischer Ansteuerung der Antriebseinheit entsprechend angetrieben wird. Das Antriebselement kann auch einen Teil der Kammer darstellen/bilden.

Erfindungsgemäß ist die Kammer, in welcher die piezoelektrische Antriebseinheit angeordnet ist, hermetisch verschlossen. Gegenwärtige Lösungen, wie z.B. der aus der WO 99/ 65 088 A1 bekannte Antrieb, schützen die piezoelektrische Antriebseinheit durch Klebungen, Dichtungen oder Passungen im besten Fall vor dem Eindringen des Mediums, bzw. des Fluides, jedoch liegt in der Regel keine Gasdichtigkeit - und somit keine hermetisch verschlossene Kammer - vor. Aus diesem Grund erfolgt z.B. durch Adsorption von Feuchtigkeit in der Klebstoffverbindung oder über Gasaustausch der Dichtungen/Passungen ein Transport von Stoffen über die Gasphase zum Inneren, wodurch ein Schutz vor Feuchtigkeit nicht gegeben ist.

Die vorliegende Erfindung ermöglicht eine kompakte Bauweise eines piezoelektrischen Aktors, welcher sich zur Bewegung oder Positionierung, insbesondere zur Nanopositionierung, unter extremen Bedingungen, insbesondere in feuchter oder wässriger Umgebung, mit sehr hoher Dehnung/Bewegung und einer hohen Zuverlässigkeit, bzw. Lebensdauer (durch die hermetische Versiegelung) einsetzen lässt. Die dafür notwendige hermetische Dichtheit von Gehäuse und Membran, insbesondere gegen den Transport von Gasen, wird durch Löten oder Verschweißen realisiert.

Somit verringert sich der benötigte Bauraum des piezoelektrischen Antriebs bzw. Aktors, insbesondere in Wirkrichtung, erheblich. Die Eignung des piezoelektrischen Antriebs "für den Einsatz in feuchter Umgebung" bedeutet nicht nur, dass die Kammer zur piezoelektrischen Antriebseinheit hermetisch abgedichtet ist, sondern dass der gesamte Antrieb, einschließlich seiner einzelnen Komponenten dafür ausgelegt ist, um den Einsatz "unter Wasser" oder in anderen fluiden oder korrosiven Medien zu realisieren.

### Begriffe und Definitionen

### Hermetischer Verschluss und hermetische Dichtung

Unter einem hermetischen Verschluss bzw. einer hermetischen Dichtung wird im Rahmen der Erfindung ein Verschluss bzw. eine Dichtung verstanden, der/die absolut dicht ist und insbesondere einen Austausch von Luft oder Wasser verhindert.

### Antriebseinheit

Die Antriebseinheit bezeichnet die piezoelektrisch verformbare Einheit, einschließlich aller piezoelektrischer Aktoren und aktorseitigen Anschlüsse, die innerhalb der hermetisch verschlossenen Kammer angeordnet sind. Leitungen, etc., die durch einen hermetisch abgedichteten Leitungsdurchgang geführt werden, zählen im engeren Sinne nicht zur Antriebseinheit, da sie nicht ausschließlich innerhalb der Kammer angeordnet sind.

### Biegeaktoren - Auslenkung, Verformung, Arbeitshub und Antriebskraft

Biegeaktoren, die im erfindungsgemäßen piezoelektrischen Antrieb zum Einsatz kommen, umfassen vorzugsweise wenigstens einen Piezokontraktor, der auf ein Substrat aufgebracht ist. Piezokontraktoren sind typischerweise flache Bauelemente. Ihre Auslenkung erfolgt quer zur Polarisationsrichtung und zum elektrischen Feld. Die Auslenkung von Kontraktoren beruht auf dem transversalen piezoelektrischen Effekt, wobei nominal bis ca. 20 µm erreicht werden. Multilayerelemente bieten gegenüber einschichtigen Piezoelementen entscheidende Vorteile für die technische Realisierung: Aufgrund der größeren Querschnittsfläche erzeugen sie höhere Kräfte bzw. können sie mit niedrigerer Ansteuerspannung betrieben werden. Durch die Kontraktion entstehen in der Piezokeramik Zugspannungen, die in der spröden Keramik Schäden verursachen können. Eine Vorspannung ist daher empfehlenswert.

Aufgebracht auf ein Substrat wirken Kontraktoren als Biegeaktoren. Für den Aufbau von Vollkeramikbiegern werden zwei aktive Piezokeramikelemente zusammengefügt und elektrisch angesteuert. Wird ein passives Substrat z. B. aus Metall oder Keramikmaterial verwendet, spricht man von Verbundbiegern. Die Piezokeramikelemente können sowohl als Einzelschichten als auch als Multilayer-Elemente ausgeführt sein.

Piezoelektrische Biegeaktoren funktionieren nach dem Prinzip von Thermobimetallen. Durch die Kopplung eines flächigen Piezokontraktors mit einer zweiten Schicht entsteht bei der Ansteuerung und Kontraktion der Keramik ein Biegemoment, welches die geringe transversale Längenänderung in eine große Biegeauslenkung senkrecht zur Kontraktion umwandelt. Je nach Geometrie sind Übersetzungsfaktoren von 30 bis 40 erreichbar, allerdings auf Kosten der Wandlungseffizienz und der Krafterzeugung. Mit piezoelektrischen Biegeaktoren können Auslenkungen bis zu einigen Millimetern bei Ansprechzeiten im Millisekundenbereich erzielt werden. Die Blockierkräfte sind jedoch relativ gering. Sie liegen typischerweise im Bereich von Millinewton bis zu wenigen Newton.

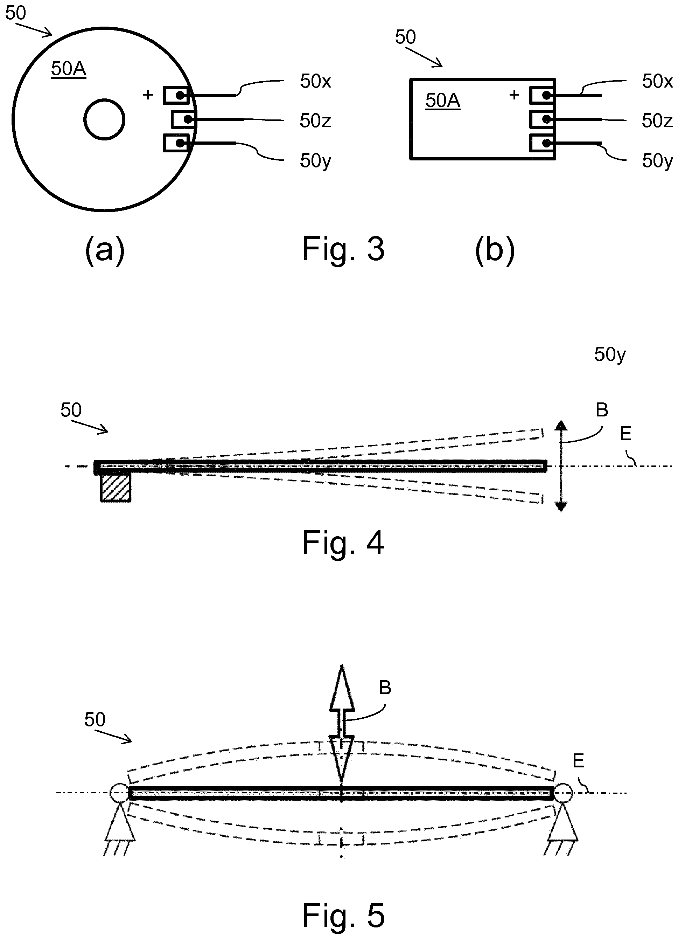

Biegeaktoren, die im erfindungsgemäßen piezoelektrischen Antrieb zum Einsatz kommen, erstrecken sich vorzugsweise im Wesentlichen in einer Ebene (Erstreckungsebene) und haben vorzugsweise eine kreisförmige, ringförmige oder quaderförmige Geometrie (bei Betrachtung senkrecht zur Erstreckungsebene). Durch elektrische Ansteuerung wird der Biegeaktor - je nach Betrachtung und angelegter Spannung - konvex oder konkav gewölbt (bei Betrachtung in der oder parallel zu der Erstreckungsebene; vgl. Figuren 4 und 5). Bei beidseitiger Einspannung des Biegeaktors wird dessen Flächenmittelpunkt im Wesentlichen senkrecht zu seiner Erstreckungsebene am stärksten ausgelenkt (vgl. Figur 5). Die Biegeauslenkung bzw. ein Arbeitshub und eine Antriebskraft in Wölbungsrichtung werden demnach quer bzw. senkrecht zur Erstreckungsebene des Biegeaktors erzeugt.

Vorteilhafte Weiterbildungen sind Gegenstände der abhängigen Ansprüche.

Es kann von Vorteil sein, wenn der Biegeaktor eine kreisförmige, ringförmige oder rechteckige Geometrie aufweist, wobei der Biegeaktor vorzugsweise in einem unverformten Ausgangszustand eben ist und bevorzugt exakt oder im Wesentlichen parallel zu der elastischen Membran ausgerichtet ist und/oder bei elektrischer Ansteuerung eine Biegeauslenkung (bzw. einen Arbeitshub und/oder eine Antriebskraft) exakt oder im Wesentlichen senkrecht zu der elastischen Membran erzeugt. Bei dieser Ausführung ist der erfindungsgemäße Antrieb besonders kompakt, insbesondere in der Wirkrichtung des Antriebs, und kann einen besonders großen Arbeitshub erzielen. Der Begriff "im Wesentlichen" soll im Rahmen dieser Erfindung jeweils eine entsprechende Abweichung von +/- 5% von einem Nominalwert abdecken.

Es kann sich als hilfreich erweisen, wenn die piezoelektrische Antriebseinheit zwei oder mehr piezoelektrische Biegeaktoren aufweist, die vorzugsweise derart in Reihe angeordnet und/oder verschaltet sind, dass sich die durch elektrische Ansteuerung erzielbaren Biegeauslenkungen (d.h. Arbeitshübe) der piezoelektrischen Biegeaktoren betragsmäßig zueinander addieren. Durch die Verwendung mehrerer Aktoren kann auf diese Weise der Arbeitshub eines einzelnen Aktors leicht vervielfacht werden.

Es kann aber auch sinnvoll sein, wenn die piezoelektrische Antriebseinheit zwei oder mehr piezoelektrische Biegeaktoren aufweist, die vorzugsweise derart parallel angeordnet und/oder verschaltet sind, dass sich die durch elektrische Ansteuerung erzielbaren Antriebskräfte der piezoelektrischen Biegeaktoren betragsmäßig zueinander addieren. Durch parallele Reihenanordnung von Biegeaktoren können die Vorteile serieller und paralleler Anordnung von Biegeaktoren optimal kombiniert werden.

Es kann sinnvoll sein, wenn die piezoelektrische Antriebseinheit zwei Biegeaktoren aufweist, die derart aneinander gekoppelt sind, dass sich bei elektrischer Ansteuerung wenigstens einer der Biegeaktoren oder beide Biegeaktoren konkav zum jeweils anderen Biegeaktor hin wölbt/wölben, wobei die Biegeaktoren vorzugsweise identisch ausgebildet und wenigstens abschnittsweise umfangsseitig aneinander gekoppelt sind, bevorzugt an voneinander abgewandten Seiten, sodass sie durch elektrische Ansteuerung symmetrisch zueinander verformbar sind, um Biegeauslenkungen (d.h. Arbeitshübe) in entgegengesetzten Richtungen zu erzielen. Bei dieser Ausführung verformen sich die Biegeaktoren konkav nach innen und konvex nach außen, wobei die maximalen Biegeauslenkungen, Arbeitshübe und/oder Antriebskräfte der Biegeaktoren exakt aufeinander ausgerichtet sind und sich die Biegeauslenkungen und Arbeitshübe betragsmäßig gegenüber einem einzelnen Biegeaktor verdoppeln. Diese Ausführung ermöglicht große Biegeauslenkungen und Arbeitshübe, besonders bei kompaktem Bauraum, insbesondere in der Wirkungsrichtung des piezoelektrischen Antriebs. Die Kopplung beider Biegeaktoren ist vorzugsweise gelenkig, elastisch, flexibel und/oder nachgiebig, um Relativbewegungen zwischen den Biegeaktoren zu kompensieren und Kraftspitzen zu vermeiden.

Es kann aber auch vorteilhaft sein, wenn die piezoelektrische Antriebseinheit mit dem Gehäuse und/oder der elastischen Membran verbunden ist, vorzugsweise fest, bevorzugt mittig, und besonders bevorzugt stoffschlüssig, beispielsweise durch Verklebung, Verschweißung, Vergießen, Löten oder formschlüssig, beispielsweise durch wenigstens einen Distanzring. Die Verbindung ist vorzugsweise gelenkig, elastisch, flexibel und/oder nachgiebig, um Relativbewegungen zwischen der Antriebseinheit und der Membran zu kompensieren und Kraftspitzen zu vermeiden.

Es ist von Vorteil, wenn die elastische Membran mit dem Gehäuse unter Ausbildung einer hermetischen Dichtung verbunden ist, bevorzugt umfangsseitig, insbesondere bevorzugt entlang einer in sich geschlossenen und in einer Ebene angeordneten Linie, und insbesondere erfindungsgemäß durch Löten oder Verschweißung. Dadurch lässt sich ein hermetischer Verschluss der Kammer auf einfache Weise bewerkstelligen.

Es kann überdies auch hilfreich sein, wenn eine Innenseite der Kammer mit einer Beschichtung versehen ist, vorzugsweise aus Kunststoff, bevorzugt aus PTFE. Dadurch kann eine Gleitreibung zwischen der Antriebseinheit und der Kammer verringert werden.

Es kann sich auch als praktisch erweisen, wenn das Gehäuse einen hermetisch verschlossenen Leitungsdurchgang zur Durchführung der Anschlüsse oder Anschlussleitungen der piezoelektrischen Antriebseinheit aufweist, vorzugsweise aus Glas. Die Anschlüsse oder Anschlussleitungen können bspw. in einen Glaspfropfen eingegossen oder eingebettet werden, welcher nachträglich in den entsprechenden Leitungsdurchgang im Gehäuse passgenau eingesetzt und dort fixiert wird, um diesen Leitungsdurchgang hermetisch zu verschließen.

Es kann von Vorteil sein, wenn das Gehäuse einen ebenen Flansch und einen sich von einer Oberseite des Flansches erhebenden, umlaufenden Rand aufweist, wobei die Kammer zumindest abschnittsweise durch die Oberseite des Flansches und/oder eine Innenseite des Rands definiert ist. Diese Ausführung ist besonders kompakt, stabil und einfach zu montieren.

Es kann überdies praktisch sein, wenn die piezoelektrische Antriebseinheit mit einem außerhalb der Kammer angeordneten Antriebselement koppelbar oder gekoppelt ist, vorzugsweise formschlüssig, wobei das Antriebselement bevorzugt die maximale Biegeauslenkung des Biegeaktors erfährt. Dieses Antriebselement kann eine universelle Schnittstelle zu weiteren anzutreibenden Elementen darstellen.

Es kann weiterhin sinnvoll sein, wenn die piezoelektrische Antriebseinheit zwei oder mehr Biegeaktoren aufweist, die durch elektrische Ansteuerung Biegeauslenkungen in die gleiche Richtung erzeugen, wobei vorzugsweise jeweils zwei Biegeaktoren derart benachbart zueinander angeordnet sind, dass sich bei elektrischer Ansteuerung einer der Biegeaktoren konkav und einer der Biegeaktoren konvex zum jeweils anderen Biegeaktor verformt, wobei die Biegeaktoren bevorzugt identisch ausgebildet und/oder wenigstens abschnittsweise flächig miteinander gekoppelt sind. Bei dieser Ausführung addieren sich die Antriebs- und Blockierkräfte der Biegeaktoren zueinander. Demnach verdoppelt sich die Antriebs- und Blockierkraft einer piezoelektrischen Antriebseinheit mit zwei derart geschalteten Biegeaktoren ohne wesentliche Erhöhung der Biegeauslenkung gegenüber einer piezoelektrischen Antriebseinheit mit einem einzelnen Biegeaktor. Diese Ausführung ermöglicht große Antriebs- und Blockierkräfte, besonders bei kompaktem Bauraum.

Es kann auch von Vorteil sein, wenn die maximale Biegeauslenkung der piezoelektrischen Antriebseinheit im Verhältnis zur Abmessung des piezoelektrischen Antriebs in Richtung der Biegeauslenkung im Bereich von 10 % bis 30 %, vorzugsweise im Bereich von 15 % bis 25 % liegt. Bei dieser Bauform ist das Verhältnis zwischen der maximalen Biegeauslenkung des piezoelektrischen Antriebs zur Abmessung des piezoelektrischen Antriebs in Richtung der Biegeauslenkung wesentlich größer als bei herkömmlichen Lösungen. So kann auf kompaktem Bauraum ein piezoelektrischer Antrieb mit einem erheblichen Stellweg bereitgestellt werden.

Ebenfalls kann es von Vorteil sein, wenn die Abmessung des piezoelektrischen Antriebs in Richtung der Biegeauslenkung im Bereich von 1,5 mm bis 20 mm, vorzugsweise im Bereich von 2 mm bis 15 mm, bevorzugt im Bereich von 5 mm bis 10 mm liegt. Piezoelektrische Antriebe mit derartigen Abmessungen sind besonders vielseitig einsetzbar.

Überdies kann es sinnvoll sein, wenn die piezoelektrische Antriebseinheit zwei oder mehr piezoelektrische Biegeaktoren aufweist, die bei elektrischer Ansteuerung jeweils eine Biegeauslenkung quer zu derselben Membran oder quer zu einer eigenen solchen Membran oder quer zu verschiedenen solchen Membranen erzeugen, wobei die unterschiedlichen Biegeaktoren vorzugsweise Biegeauslenkungen in unterschiedlichen, vorzugsweise parallelen und/oder entgegengesetzten Richtungen erzeugen. Demnach kann beispielsweise jeweils eine Membran auf jeder Seite des piezoelektrischen Antriebs angeordnet sein, was eine Koppelung eines Antriebselements auf beiden Seiten des piezoelektrischen Antriebs oder eine Koppelung von zwei oder mehr piezoelektrischen Antrieben miteinander ermöglicht. Ebenso können demnach zwei oder mehr parallel geschaltete Biegeaktoren des piezoelektrischen Antriebs von einer Membran überspannt werden.

Weitere vorteilhafte Weiterbildungen der Erfindung ergeben sich durch Kombinationen der in Ansprüchen, Beschreibung und Zeichnungen offenbarten Merkmale.

### Kurze Beschreibung der Figuren

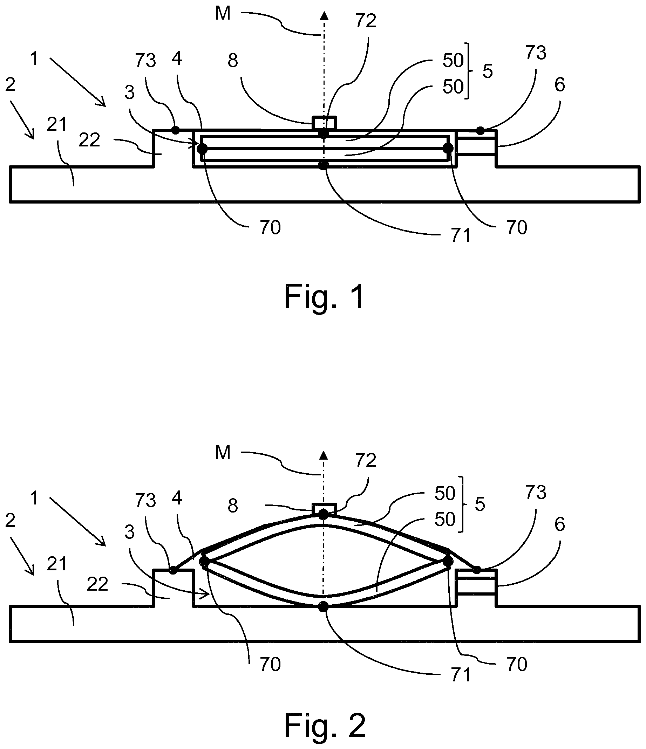

Figur 1 zeigt schematisch einen piezoelektrischen Antrieb nach dem ersten Ausführungsbeispiel der Erfindung mit einem Gehäuse und einer durch eine elastische Membran hermetisch verschlossenen Kammer, wobei sich eine in der Kammer angeordnete, piezoelektrische Antriebseinheit im Ausgangszustand befindet.
Figur 2 zeigt schematisch den piezoelektrischen Antrieb aus Figur 1, wobei sich die in der Kammer angeordnete, piezoelektrische Antriebseinheit im Verformungszustand befindet und die elastische Membran verformt ist. Zu Anschauungszwecken ist der Grad der Verformung der piezoelektrischen Antriebseinheit im Verformungszustand gegenüber dem Ausgangszustand stark übertrieben dargestellt.
Figur 3 zeigt schematische Draufsichten verschiedener piezoelektrischer Biegeaktoren mit entsprechenden Anschlüssen zur Verwendung in der piezoelektrischen Antriebseinheit; Ansicht (a) zeigt insbesondere einen ebenen Biegeaktor mit ringförmiger Geometrie und Ansicht (b) einen ebenen Biegeaktor mit rechteckiger Geometrie.
Figur 4 zeigt schematisch die Biegeauslenkung eines piezoelektrischen Biegeaktors bei einseitiger, fester Einspannung.
Figur 5 zeigt schematisch die Biegeauslenkung eines piezoelektrischen Biegeaktors bei zweiseitiger Einspannung mit drehbarer Lagerung.

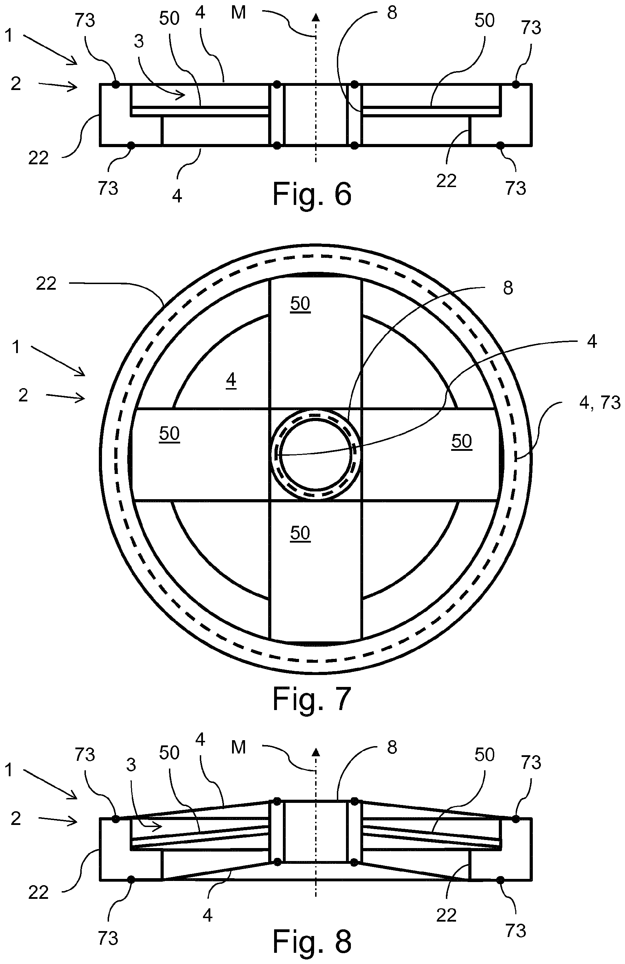

Figur 6 zeigt schematisch einen piezoelektrischen Antrieb nach dem zweiten Ausführungsbeispiel der Erfindung mit einem ringförmigen Gehäuse und einer durch zwei elastische Membranen hermetisch verschlossenen Kammer, in welcher rechteckige Biegeaktoren kreuzförmig und radial zu einem mittigen Antriebselement angeordnet sind, wobei sich die piezoelektrische Antriebseinheit im Ausgangszustand befindet.
Figur 7 zeigt schematisch den piezoelektrischen Antrieb aus Figur 6 in der Draufsicht, wobei die obere Membran zu Anschauungszwecken transparent dargestellt ist.
Figur 8 zeigt schematisch einen piezoelektrischen Antrieb nach dem zweiten Ausführungsbeispiel der Erfindung, wobei sich die piezoelektrische Antriebseinheit im Verformungszustand befindet.

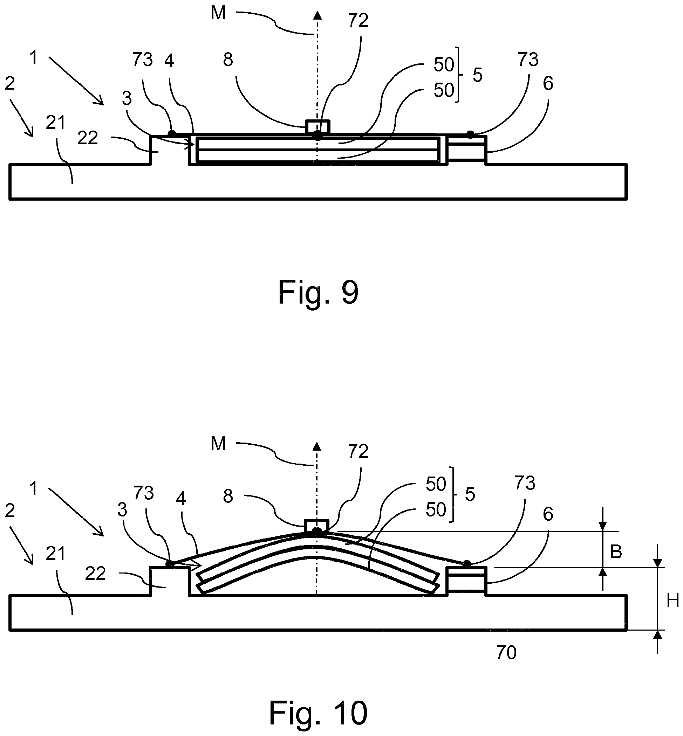

Figur 9 zeigt schematisch einen piezoelektrischen Antrieb nach dem dritten Ausführungsbeispiel der Erfindung mit einem Gehäuse und einer durch eine elastische Membran hermetisch verschlossenen Kammer, wobei sich eine in der Kammer angeordnete, piezoelektrische Antriebseinheit im Ausgangszustand befindet.
Figur 10 zeigt schematisch den piezoelektrischen Antrieb aus Figur 9, wobei ein Biegeaktor der piezoelektrischen Antriebseinheit konkav und ein Biegeaktor konvex zum jeweils anderen Biegeaktor verformt ist und die elastische Membran verformt ist. Zu Anschauungszwecken ist der Grad der Verformung der piezoelektrischen Antriebseinheit im Verformungszustand gegenüber dem Ausgangszustand stark übertrieben dargestellt.

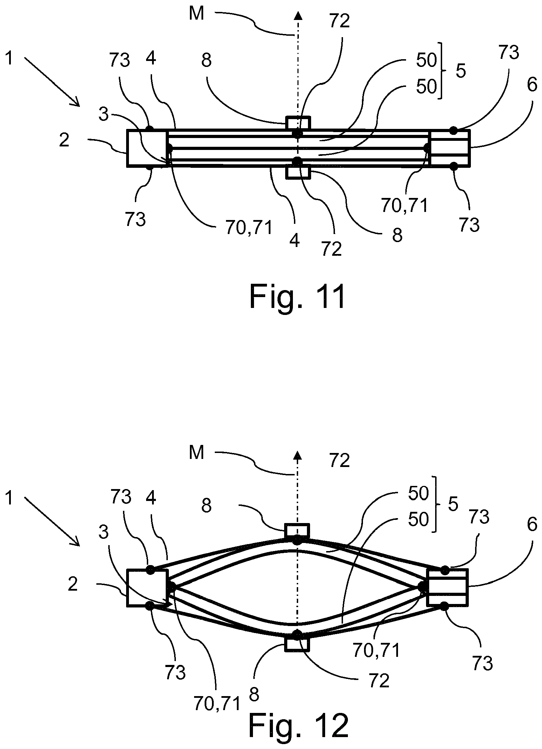

Figur 11 zeigt schematisch einen piezoelektrischen Antrieb nach dem vierten Ausführungsbeispiel der Erfindung mit einem Ring als Gehäuse und einer durch zwei elastische Membranen hermetisch verschlossenen Kammer, wobei sich eine in der Kammer angeordnete, piezoelektrische Antriebseinheit im Ausgangszustand befindet.
Figur 12 zeigt schematisch den piezoelektrischen Antrieb aus Figur 1, wobei sich die in der Kammer angeordnete, piezoelektrische Antriebseinheit im Verformungszustand befindet, wobei die Biegeaktoren jeweils konkav zueinander verformt sind und elastischen Membranen auf beiden Seiten des piezoelektrischen Antriebs jeweils verformt sind. Zu Anschauungszwecken ist der Grad der Verformung der piezoelektrischen Antriebseinheit im Verformungszustand gegenüber dem Ausgangszustand stark übertrieben dargestellt.

### Detaillierte Beschreibung der bevorzugten Ausführungsbeispiele

Die erfindungsgemäße Vorrichtung und deren einzelne Komponenten werden nachstehend mit Bezug auf die beiliegenden Zeichnungen im Detail beschrieben.

Der piezoelektrische Antrieb 1 nach dem ersten Ausführungsbeispiel der Erfindung umfasst ein Gehäuse 2 mit einem ebenen Flansch 21, an dessen Oberseite sich senkrecht zum Flansch 21 ein umlaufender Rand 22 erstreckt. Innerhalb des umlaufenden Rands 22 ist eine Kammer 3 zur Aufnahme der piezoelektrischen Antriebseinheit 5 ausgebildet. Die Kammer 3 ist oberseitig durch eine kreisförmige und elastische Membran 4 hermetisch verschlossen.

Das starre bzw. steife Gehäuse 2 besteht aus einem luftdichten und/oder wasserdichten Material und erfindungsgemäß aus Metall. Die elastische Membran 4 besteht ebenfalls aus einem luftdichten und/oder wasserdichten Material, ist jedoch elastisch und erfindungsgemäß ebenfalls aus Metall, sodass eine Vielzahl von Verformungszyklen (> 10.000) über eine lange Zeitdauer (> 10 Jahre) ohne Materialversprödung möglich ist. Material, Dicke und Beschaffenheit des Gehäuses 2 und der Membran 4 sind nach praktischen Gesichtspunkten vorzugsweise derart ausgewählt, um eine Langlebigkeit des piezoelektrischen Antriebs 1 über die gesamte Lebensdauer des anzutreibenden Produkts sicherzustellen.

Optional kann die piezoelektrische Antriebseinheit 5 umfangseitig an der Innenseite der Kammer 3 geführt werden. Die Innenseite der Kammer 3 kann dazu mit einer Beschichtung, Fütterung oder Auskleidung versehen sein, beispielsweise aus PTFE, um die Kontaktreibung zwischen der Antriebseinheit 5 und der Kammer 3 zu minimieren.

Die piezoelektrische Antriebseinheit 5 umfasst zwei identische Biegeaktoren 50 mit kreisförmiger oder ringförmiger Geometrie in der Draufsicht, die umfangseitig zumindest abschnittsweise aneinander gekoppelt sind, sich in einem unverformten Ausgangszustand in einer Ebene (Erstreckungsebene) erstrecken und durch elektrische Ansteuerung in einen nach außen konvex gewölbten Verformungszustand (Figur 2) überführbar sind.

Anstelle der Biegeaktoren 50 mit kreisförmiger oder ringförmiger Geometrie können auch Biegeaktoren 50 mit anderen Geometrien, insbesondere Biegeaktoren 50 mit rechteckiger Geometrie, eingesetzt werden. Die Geometrien der Kammer 3 (Innenumfang) und der Biegeaktoren 50 (Außenumfang) sind vorzugsweise aufeinander abgestimmt. Biegeaktoren 50 mit kreisförmiger/ringförmiger und rechteckiger Geometrie in der Draufsicht sind in den Ansichten (a) bzw. (b) der Figur 3 schematisch dargestellt.

Jeder piezoelektrische Biegeaktor 50 ist aus piezokeramischen Schichten und inneren Elektroden aufgebaut. Die inneren Elektroden sind vollflächig im Inneren des Biegeaktors 50 in mehreren Lagen zwischen den piezokeramischen Schichten angeordnet und besitzen die Form der äußeren Geometrie der piezokeramischen Schichten abzüglich der Isolationsbereiche (Umfangsrand des ringförmigen Biegeaktors in Ansicht (a); Querseite des rechteckigen Biegeaktors in Ansicht (b)) und sind mit vorzugsweise drei externen Elektroden (bei Verklebung mit einem Substrat sind es nur zwei Kontakte; allerdings sind auch vier Kontakte möglich), die auch als Lötanschlussstellen bezeichnet werden, verbunden. Wenn über die Anschlüsse bzw. Anschlussleitungen 50x, 50y, 50z eine Spannung (Steuerspannung) der korrekten Polarität an den Lötanschlussstellen angelegt wird, erhöht sich die Dicke der piezokeramischen Schichten und deren Länge verkürzt sich. Das Biegemoment bzw. der Arbeitshub und die daraus resultierende Arbeitskraft werden durch die Kontraktion ("d31-Effekt") bewirkt.

Die Art der Verformung der piezoelektrischen Biegeaktoren 50 richtet sich nach der Art der Befestigung. Mit Blickrichtung in der jeweiligen Erstreckungsebene des Biegeaktors 50 sind die durch elektrische Ansteuerung erzielbaren Biegeauslenkungen schematisch in den Figuren 4 und 5 dargestellt.

Bei einseitiger Einspannung ("cantilever") des piezoelektrischen Biegeaktors 50 wird das von dem eingespannten Ende abgewandte Ende des Biegeaktors 50 am stärksten aus der Erstreckungsebene E ausgelenkt, wie in Figur 4 schematisch dargestellt ist.

Bei beidseitiger Einspannung wird ein zwischen den Einspannenden liegender Bereich, insbesondere ein Flächenmittelpunkt des Biegeaktors 50, am stärksten aus der Erstreckungsebene E ausgelenkt, wie in Figur 5 schematisch dargestellt ist.

Wie aus den Figuren 4 und 5 ersichtlich ist, verläuft die durch elektrische Ansteuerung erzielbare Biegeauslenkung B in beiden Auslenkungsrichtungen jeweils senkrecht zur Erstreckungsebene E des Biegeaktors 50. Im Fall der umgekehrten Ansteuerung wird ein Antriebshub beim Abschalten der elektrischen Spannung erzielt.

Wird eine Spannung (Steuerspannung) zwischen zweien der (zwei bis vier) Lötanschlussstellen angelegt, beispielsweise über die Anschlussleitungen 50x und 50z (Figur 3), biegt sich der Biegeaktor 50 lediglich in eine Richtung, wobei sich die aktiven piezokeramischen Schichten in der Länge zusammenziehen, während die anderen Schichten passiv sind und keiner Formänderung unterliegen.

Die ringförmigen Biegeaktoren 50 haben beispielsweise einen Durchmesser von 25 mm, eine Dicke von 0,48 mm und einen maximalen Arbeitshub von +/-120 µm entlang der Mittelachse M. Die Mittelachsen der Biegeaktoren 50, entlang welcher die Biegeauslenkungen, Arbeitskräfte und Arbeitshübe erzeugt werden, fallen mit der Mittelachse M der Kammer 3 zusammen.

Die Biegeaktoren 50 sind im Ausgangszustand (Figur 1) parallel zueinander angeordnet sowie umfangsseitig umlaufend oder lediglich punktuell an diametral gegenüberliegenden Seiten gelenkig miteinander verbunden, wie in den Figuren 1 und 2 durch die Verbindungspunkte 70 schematisch veranschaulicht wird. Ferner erstrecken sich die beiden Biegeaktoren 50 im unverformten Ausgangszustand (Figur 1), in welchem auch die elastische Membran 4 unverformt ist, parallel zu der elastischen Membran 4 sowie parallel zu dem Boden des Gehäuses 2 am unteren Ende der Kammer 3.

Der untere Biegeaktor 50 ist an seiner Unterseite mittig mit dem Boden des Gehäuses 2 am unteren Ende der Kammer 3 verbunden, wie durch den Verbindungspunkt 71 schematisch dargestellt wird. Der obere Biegeaktor 50 ist an seiner Oberseite mittig mit der elastischen Membran 4 verbunden, wie durch den Verbindungspunkt 72 schematisch dargestellt wird.

Die Biegeaktoren 50 sind derart elektrisch und mechanisch aneinander gekoppelt, dass sie sich bei elektrischer Ansteuerung spiegelsymmetrisch zueinander verformen und konkav zueinander in einen jeweils kuppelförmigen Verformungszustand wölben. Im Verformungszustand, der in Figur 2 schematisch dargestellt ist, ist der jeweilige Mittelpunkt des Biegeaktors 50 aus dessen Erstreckungsebene, die durch den Umfang des Biegeaktors 50 definiert ist, nach oben bzw. nach unten versetzt. Die maximale Biegeauslenkung des Mittelpunkts des Biegeaktors 50 gegenüber dessen Erstreckungsebene definiert den Arbeitshub des Biegeaktors 50. Durch entsprechende Ansteuerung können sich die entgegengesetzten Biegeauslenkungen und Arbeitshübe der seriell angeordneten Biegeaktoren 50 betragsmäßig addieren. Wahlweise kann auch nur einer der Biegeaktoren 50 elektrisch angesteuert werden, um sich konkav zum anderen Biegeaktor 50 zu wölben, während der andere Biegeaktor 50 passiv im ebenen Ausgangszustand verbleibt und nicht verformt wird. Durch die piezoelektrische Verformung der Antriebseinheit 5 wird die über die Kammer 3 gespannte Membran 4 elastisch verformt.

Zu Anschauungszwecken sind die piezoelektrische Verformung der durch die Biegeaktoren 50 gebildeten, piezoelektrischen Antriebseinheit 5 sowie die Verformung der Membran 4 stark übertrieben dargestellt. Der tatsächliche Arbeitshub, der durch die piezoelektrische Antriebseinheit 5 mit zwei Biegeaktoren 50 eines Durchmessers von jeweils 25 mm darstellbar ist, liegt im Bereich von ca. 240 µm.

Durch elektrische Ansteuerung der piezoelektrischen Antriebseinheit 5 wird ein außerhalb der Kammer 3 angeordnetes Antriebselement 8, das mit der Antriebseinheit 5 koppelbar oder gekoppelt ist, durch die Biegeauslenkungen der Biegeaktoren 50 entlang der Mittelachse M, d.h. senkrecht zur Erstreckungsrichtung der elastischen Membran 4 in unverformten Zustand versetzt.

Durch die Anordnung und Verschaltung der Biegeaktoren 50 in Reihe addieren sich die Biegeauslenkungen und Arbeitshübe der beiden Biegeaktoren 50 bei einer elektrischen Ansteuerung zueinander, so dass sie sich gegenüber einem einzelnen Biegeaktor 50 verdoppeln.

Eine parallele Anordnung und Verschaltung der Biegeaktoren 50 ist ebenso möglich. Hierdurch addieren sich die Antriebskräfte der Biegeaktoren 50 bei einer elektrischen Ansteuerung zueinander. Demnach verdoppelt sich die Antriebskraft einer piezoelektrischen Antriebseinheit 5 mit zwei parallel geschalteten Biegeaktoren 50 gegenüber einer piezoelektrischen Antriebseinheit 5 mit einem einzelnen Biegeaktor 50 .

Vorteilhaft für einen parallelen Betrieb der Biegeaktoren 50 ist das Weglassen der Verbindungsstelle 71 zum Flansch 21, wobei die Lagerung/Befestigung der Biegeaktoren 50 an dem umlaufenden Rand 22 des Gehäuses 2 erfolgen kann.

Ein zweites Ausführungsbeispiel der Erfindung wird nachstehend mit Bezug auf die Figuren 6 bis 8 beschrieben. Ähnliche Elemente wie im ersten Ausführungsbeispiel der Erfindung sind mit gleichen Bezugszeichen wie im ersten Ausführungsbeispiel bezeichnet. Zur Erläuterung der Funktion dieser Elemente wird auf die Beschreibung der Bezugszeichen im Zusammenhang mit dem ersten Ausführungsbeispiel verwiesen, um eine Wiederholung zu vermeiden.

Im Folgenden wird demnach im Wesentlichen auf die Unterschiede zum ersten Ausführungsbeispiel eingegangen.

Der piezoelektrische Antrieb nach dem zweiten Ausführungsbeispiel umfasst, abweichend vom ersten Ausführungsbeispiel, mehrere Biegeaktoren 50, die parallel zueinander angeordnet sind.

Bei paralleler Anordnung und Verschaltung der Biegeaktoren 50 addieren sich die Antriebskräfte der Biegeaktoren 50 bei einer elektrischen Ansteuerung zueinander. Demnach verdoppelt sich die Antriebskraft einer piezoelektrischen Antriebseinheit 5 mit zwei parallel geschalteten Biegeaktoren 50 gegenüber einer piezoelektrischen Antriebseinheit 5 mit einem einzelnen Biegeaktor 50.

In der Anordnung der Biegeaktoren 50 in Reihe, bzw. in der parallelen Anordnung der Biegeaktoren 50, kann auch ein Vielfaches der Biegeaktoren 50 verwendet werden, um die Auslenkung, und Arbeitshübe, bzw. die Arbeitskräfte nicht nur zu verdoppeln, sondern zu vervielfachen.

Durch die Anordnung von parallelen Biegeaktoren 50 in einer Reihe lassen sich die Vorteile von paralleler und Reihenanordnung kombinieren.

Ein entsprechend modifiziertes Gehäuse 2 weist wahlweise ein Durchgangsloch 23 für Biegeaktoren 50 ohne oder mit Innenloch auf. Dieses Gehäuse 2 sowie die Biegeaktoren 50 und das Innenloch können eine runde oder rechteckige Geometrie aufweisen. Für den Aufbau sind mindestens zwei Biegeaktoren 50 notwendig.

Der piezoelektrische Antrieb nach dem zweiten Ausführungsbeispiel der Erfindung, der in den Figuren 6 bis 8 schematisch dargestellt ist, weist ein Gehäuse 2 mit bodenseitigem Loch 23 und vier rechteckige Biegeaktoren 50 ohne Loch auf. Die insgesamt vier Biegeaktoren 50 sind kreuzförmig und radial zur Mittelachse M des ringförmigen Gehäuses 2 und einem mittig angeordneten Antriebselement 8 angeordnet. Das Gehäuse 2 ist hierbei hohlzylindrisch mit unterschiedlichen Innendurchmessern ausgebildet. Die Biegeaktoren 50 liegen mit ihrem radial außenseitigen Ende auf einer nach oben weisenden, ringförmigen Stufe innerhalb des umlaufenden Rands 22 des Gehäuses 2. Abweichend vom ersten Ausführungsbeispiel umfasst das Gehäuse 2 keinen Flansch 21. Das radial innenseitige Ende der Biegeaktoren 50 ist jeweils an dem hohlzylindrischen Antriebselement 8 vorzugsweise stoff- und formschlüssig befestigt.

Die Kammer 3 wird durch das ringförmige Gehäuse 2 und das mittig angeordnete, zylindrische Abtriebselement 8 definiert und oberseitig sowie unterseitig durch bspw. ringförmige Membranen 4 hermetisch verschlossen.

Diese Ausführung begünstigt das Einsetzen von optischen Linsen, optisch aktiven Materialien oder transparenten Materialien insbesondere in dem Flansch 21 und/oder in der Membran 4.

Weiterhin können die Biegeaktoren 50 mit einer reflektierenden Oberfläche für elektromagnetische Strahlung beschichtet werden, welche insbesondere für den Fall mit den optischen Durchgängen eingesetzt werden können.

Ein drittes Ausführungsbeispiel der Erfindung wird nachstehend mit Bezug auf die Figuren 9 bis 10 beschrieben. Ähnliche Elemente wie im ersten Ausführungsbeispiel der Erfindung sind mit gleichen Bezugszeichen wie im ersten Ausführungsbeispiel bezeichnet. Zur Erläuterung der Funktion dieser Elemente wird auf die Beschreibung der Bezugszeichen im Zusammenhang mit dem ersten Ausführungsbeispiel verwiesen, um eine Wiederholung zu vermeiden.

Der piezoelektrische Antrieb 1 nach dem dritten Ausführungsbeispiel unterscheidet sich vom ersten Ausführungsbeispiel im Wesentlichen dadurch, dass die Biegeauslenkung der Biegeaktoren 50 bei elektrischer Ansteuerung in die gleiche Richtung erfolgt.

Die identisch ausgebildeten Biegeaktoren 50 sind im Ausgangszustand (Figur 9) parallel zueinander angeordnet und stehen über jeweils eine Fläche miteinander in Kontakt. Der untere Biegeaktor liegt auf dem Boden des Gehäuses 2 am unteren Ende der Kammer 3 auf.

Die Biegeaktoren sind derart elektrisch und mechanisch aneinander gekoppelt, dass sich bei elektrischer Ansteuerung der obere Biegeaktor 50 konkav und der untere Biegeaktor 50 konvex zum jeweils anderen Biegeaktor 50 verformt (Figur 10). Hierdurch erfolgt die jeweilige Biegeauslenkung der Biegeaktoren 50 in die gleiche Richtung und die Antriebskräfte der Biegeaktoren 50 addieren sich bei einer elektrischen Ansteuerung zueinander. Demnach verdoppelt sich die Antriebs- und Blockierkraft einer piezoelektrischen Antriebseinheit 5 mit zwei derart geschalteten Biegeaktoren 50 im Wesentlichen ohne Erhöhung der Biegeauslenkung gegenüber einer piezoelektrischen Antriebseinheit 5 mit einem einzelnen Biegeaktor 50.

Die Oberfläche der jeweiligen Biegeaktoren 50 ist derart beschaffen, dass bei elektrischer Ansteuerung die jeweiligen Kontaktflächen der Biegeaktoren 50 aneinander gleiten können.

Nach gleichem Prinzip können auch mehr als zwei Biegeaktoren 50 derart aneinander gekoppelt werden, dass sie flächig aneinander liegen und bei elektrischer Ansteuerung jeweils eine Biegeauslenkung in die gleiche Richtung erzeugen.

Ein viertes Ausführungsbeispiel der Erfindung wird nachstehend mit Bezug auf die Figuren 11 bis 12 beschrieben. Ähnliche Elemente wie im ersten Ausführungsbeispiel der Erfindung sind mit gleichen Bezugszeichen wie im ersten Ausführungsbeispiel bezeichnet. Zur Erläuterung der Funktion dieser Elemente wird auf die Beschreibung der Bezugszeichen im Zusammenhang mit dem ersten Ausführungsbeispiel verwiesen, um eine Wiederholung zu vermeiden.

Der piezoelektrische Antrieb 1 nach dem vierten Ausführungsbeispiel unterscheidet sich vom ersten Ausführungsbeispiel im Wesentlichen dadurch, dass das Gehäuse 2 ab Ring ausgebildet ist und das Gehäuse 2 auf beiden Seiten jeweils von einer Membran 4 verschlossen ist.

Die Biegeaktoren 50 sind im Ausgangszustand (Figur 11) parallel zueinander angeordnet sowie umfangsseitig umlaufend oder lediglich punktuell an diametral gegenüberliegenden Seiten gelenkig miteinander verbunden und am Gehäuse 2 befestigt.

Die Biegeaktoren 50 sind derart elektrisch und mechanisch aneinander gekoppelt, dass sie sich bei elektrischer Ansteuerung spiegelsymmetrisch zueinander verformen und konkav zueinander in einen jeweils kuppelförmigen Verformungszustand wölben. Über die Verformung der Biegeaktoren 50 werden die obere und die untere Membran 4 in entgegengesetzte Richtungen verformt. Bei diesem Ausführungsbeispiel kann demnach eine Anbindung/Koppelung an ein Antriebselement auf beiden Seiten der piezoelektrischen Antriebseinheit erfolgen. Nach diesem Prinzip können auch zwei oder mehr piezoelektrische Antriebseinheiten 5 oder Antriebe 1 auf eine Weise miteinander gekoppelt werden, dass sie bei elektrischer Ansteuerung Biegeauslenkung in unterschiedliche Richtungen erzeugen, beispielsweise in parallele Richtungen oder in entgegengesetzte Richtungen.

Die oben beschriebenen Ausführungsbeispiele können in beliebiger Weise miteinander kombiniert werden. Insbesondere können die Ausführungsbeispiele drei und vier in einer Weise miteinander kombiniert werden, dass zwei oder mehr Biegeaktoren 50 bei elektrischer Ansteuerung Biegeauslenkungen in eine erste Richtung erzeugen, während zwei oder mehr (andere) Biegeaktoren 50 bei elektrischer Ansteuerung Biegeauslenkungen in eine zweite Richtung erzeugen, wobei die erste Richtung vorzugsweise entgegengesetzt zur ersten Richtung ist.

### Bezugszeichenliste

- 1: Piezoelektrischer Antrieb
- 2: Gehäuse
- 3: Kammer
- 4: Elastische Membran
- 5: Piezoelektrische Antriebseinheit
- 6: Leitungsdurchgang
- 8: Antriebselement
- 21: Flansch
- 22: Rand
- 23: Durchgangsloch
- 50: Piezoelektrischer Aktor (Biegeaktor)
- 50A: Oberseite
- 50x: Positiver Spannungsanschluss
- 50y: Negativer Spannungsanschluss
- 50z: Erdung
- 70: Verbindung zwischen piezoelektrischen Aktoren
- 71: Verbindung zwischen piezoelektrischer Antriebseinheit und Gehäuse
- 72: Verbindung zwischen piezoelektrischer Antriebseinheit und Membran
- 73: Verbindung zwischen Membran und Gehäuse
- B: Biegeauslenkung
- E: Erstreckungsebene
- H: Abmessung des piezoelektrischen Antriebs (Höhe) in Richtung der Biegeauslenkung
- M: Mittelachse (der piezoelektrischen Antriebseinheit und der Kammer)

## Patentansprüche

1. Piezoelektrischer Antrieb (1), insbesondere für den Einsatz in feuchter Umgebung, Z umfassend ein Gehäuse (2) mit einer Kammer (3), die durch eine elastische Membran (4) aus Metall hermetisch verschlossen ist, wobei eine piezoelektrische Antriebseinheit (5) in der hermetisch verschlossenen Kammer (3) angeordnet und zum Antrieb eines Antriebselements (8) durch elektrische Ansteuerung piezoelektrisch verformbar ist, und die piezoelektrische Antriebseinheit (5) wenigstens einen piezoelektrischen Biegeaktor (50) aufweist, der bei elektrischer Ansteuerung eine Biegeauslenkung quer zu der elastischen Membran (4) erzeugt, **dadurch gekennzeichnet, dass** das Gehäuse (2) aus Metall besteht und die elastische Membran (4) durch Löten oder Schweißen mit dem Gehäuse (2) verbunden ist.

2. Piezoelektrischer Antrieb (1) nach Anspruch 1, **dadurch gekennzeichnet, dass** der Biegeaktor (50) eine kreisförmige, ringförmige oder rechteckige Geometrie aufweist, wobei der Biegeaktor (50) vorzugsweise in einem unverformten Ausgangszustand eben ist und bevorzugt exakt oder im Wesentlichen parallel zu der elastischen Membran (4) ausgerichtet ist und/oder bei elektrischer Ansteuerung eine Biegeauslenkung exakt oder im Wesentlichen senkrecht zu der elastischen Membran (4) erzeugt.

3. Piezoelektrischer Antrieb (1) nach einem der vorangehenden Ansprüche, **dadurch gekennzeichnet, dass** die piezoelektrische Antriebseinheit (5) zwei oder mehr piezoelektrische Biegeaktoren (50) aufweist, die vorzugsweise derart in Reihe angeordnet und/oder verschaltet sind, dass sich die durch elektrische Ansteuerung erzielbaren Biegeauslenkungen der piezoelektrischen Biegeaktoren (50) betragsmäßig zueinander addieren.

4. Piezoelektrischer Antrieb (1) nach einem der vorangehenden Ansprüche, **dadurch gekennzeichnet, dass** die piezoelektrische Antriebseinheit (5) zwei oder mehr piezoelektrische Biegeaktoren (50) aufweist, die vorzugsweise derart parallel angeordnet und/oder verschaltet sind, dass sich die durch elektrische Ansteuerung erzielbaren Antriebskräfte der piezoelektrischen Biegeaktoren (50) betragsmäßig zueinander addieren.

5. Piezoelektrischer Antrieb (1) nach einem der vorangehenden Ansprüche, **dadurch gekennzeichnet, dass** die piezoelektrische Antriebseinheit (5) zwei Biegeaktoren (50) aufweist, die derart aneinander gekoppelt sind, dass sich bei elektrischer Ansteuerung wenigstens einer der Biegeaktoren (50) oder beide Biegeaktoren (50) konkav zum jeweils anderen Biegeaktor (50) hin wölbt/wölben, wobei die Biegeaktoren (50) vorzugsweise identisch ausgebildet und wenigstens abschnittsweise umfangsseitig aneinander gekoppelt sind, bevorzugt an voneinander abgewandten Seiten, sodass sie durch elektrische Ansteuerung symmetrisch zueinander verformbar sind, um Biegeauslenkungen in entgegengesetzten Richtungen zu erzeugen.

6. Piezoelektrischer Antrieb (1) nach einem der vorangehenden Ansprüche, **dadurch gekennzeichnet, dass** die piezoelektrische Antriebseinheit (5) mit dem Gehäuse (2) und/oder der elastischen Membran (4) verbunden ist, vorzugsweise fest, bevorzugt mittig, und besonders bevorzugt stoffschlüssig, beispielsweise durch Verklebung, Verschweißung, Löten, oder formschlüssig, beispielsweise durch wenigstens einen Distanzring.

7. Piezoelektrischer Antrieb (1) nach einem der vorangehenden Ansprüche, **dadurch gekennzeichnet, dass** die elastische Membran (4) mit dem Gehäuse (2) unter Ausbildung einer hermetischen Dichtung verbunden ist, bevorzugt umfangsseitig, insbesondere bevorzugt entlang einer in sich geschlossenen und in einer Ebene angeordneten Linie.

8. Piezoelektrischer Antrieb (1) nach einem der vorangehenden Ansprüche, **dadurch gekennzeichnet, dass** eine Innenseite der Kammer (3) mit einer Beschichtung versehen ist, vorzugsweise aus Kunststoff, bevorzugt aus PTFE.

9. Piezoelektrischer Antrieb (1) nach einem der vorangehenden Ansprüche, **dadurch gekennzeichnet, dass** das Gehäuse (2) einen hermetisch verschlossenen Leitungsdurchgang zur Durchführung von Anschlüssen oder Anschlussleitungen (50x, 50y, 50x) der piezoelektrischen Antriebseinheit (5) aufweist, vorzugsweise aus Glas.

10. Piezoelektrischer Antrieb (1) nach einem der vorangehenden Ansprüche, **dadurch gekennzeichnet, dass** das Gehäuse (2) einen ebenen Flansch (21) und einen sich von einer Oberseite des Flansches (21) erhebenden, umlaufenden Rand (22) aufweist, wobei die Kammer (3) zumindest abschnittsweise durch die Oberseite des Flansches (21) und/oder eine Innenseite des Rands (22) definiert ist.

11. Piezoelektrischer Antrieb (1) nach einem der vorangehenden Ansprüche, **dadurch gekennzeichnet, dass** die piezoelektrische Antriebseinheit (5) mit einem außerhalb der Kammer (3) angeordneten Antriebselement (8) koppelbar oder gekoppelt ist, vorzugsweise formschlüssig, wobei das Antriebselement (8) bevorzugt die maximale Biegeauslenkung des Biegeaktors (50) erfährt.

12. Piezoelektrischer Antrieb (1) nach einem der vorangehenden Ansprüche, **dadurch gekennzeichnet, dass** die piezoelektrische Antriebseinheit (5) zwei oder mehr Biegeaktoren (50) aufweist, die durch elektrische Ansteuerung Biegeauslenkungen in die gleiche Richtung erzeugen, wobei vorzugsweise jeweils zwei Biegeaktoren (50) derart benachbart zueinander angeordnet sind, dass sich bei elektrischer Ansteuerung einer der Biegeaktoren (50) konkav und einer der Biegeaktoren konvex zum jeweils anderen Biegeaktor (50) verformt, wobei die Biegeaktoren (50) bevorzugt identisch ausgebildet und/oder wenigstens abschnittsweise flächig miteinander gekoppelt sind.

13. Piezoelektrischer Antrieb (1) nach einem der vorangehenden Ansprüche, **dadurch gekennzeichnet, dass** die maximale Biegeauslenkung (B) der piezoelektrischen Antriebseinheit (5) im Verhältnis zur Abmessung (H) des piezoelektrischen Antriebs (1) in Richtung der Biegeauslenkung (B) im Bereich von 10 % bis 30 %, vorzugsweise im Bereich von 15 % bis 25 % liegt.

14. Piezoelektrischer Antrieb (1) nach einem der vorangehenden Ansprüche, **dadurch gekennzeichnet, dass** die Abmessung (H) des piezoelektrischen Antriebs (1) in Richtung der Biegeauslenkung (B) im Bereich von 1,5 mm bis 20 mm, vorzugsweise im Bereich von 2 mm bis 15 mm, bevorzugt im Bereich von 5 mm bis 10 mm liegt.

15. Piezoelektrischer Antrieb (1) nach einem der vorangehenden Ansprüche, **dadurch gekennzeichnet, dass** die piezoelektrische Antriebseinheit (5) zwei oder mehr piezoelektrische Biegeaktoren (50) aufweist, die bei elektrischer Ansteuerung jeweils eine Biegeauslenkung quer zu derselben Membran (4) oder quer zu einer eigenen solchen Membran (4) oder quer zu verschiedenen solchen Membranen (4) erzeugen, wobei die unterschiedlichen Biegeaktoren (50) vorzugsweise Biegeauslenkungen in unterschiedlichen, vorzugsweise parallelen und/oder entgegengesetzten Richtungen erzeugen.

## Claims

1. A piezoelectric drive (1), in particular for use in a moist environment, comprising: a housing (2) having a chamber (3), which is hermetically sealed by an elastic membrane (4) made of metal, a piezoelectric drive unit (5) being arranged in the hermetically sealed chamber (3) and adapted to be piezoelectrically deformed by electric actuation for driving a drive element (8), and the piezoelectric drive unit (5) comprises at least one piezoelectric bending actuator (50) generating, when electrically actuated, a bending deflection transversely to the elastic membrane (4), **characterized in that** the housing (2) is made of metal and the elastic membrane (4) is connected to the housing (2) by soldering or welding.

2. The piezoelectric drive (1) according to claim 1, **characterized in that** the piezoelectric bending actuator (50) has a circular, annular or rectangular geometry, the bending actuator (50) being preferably flat in an undeformed initial state and preferably oriented precisely or substantially parallel to the elastic membrane (4) and/or generating, when electrically actuated, a bending deflection precisely or substantially perpendicular to the elastic membrane (4).

3. The piezoelectric drive (1) according to one of the preceding claims, **characterized in that** the piezoelectric drive unit (5) comprises two or more piezoelectric bending actuators (50), which are preferably arranged and/or interconnected in series such that the bending deflections of the piezoelectric bending actuators (50), which can be accomplished by electric actuation, will add up in magnitude.

4. The piezoelectric drive (1) according to one of the preceding claims, **characterized in that** the piezoelectric drive unit (5) comprises two or more piezoelectric bending actuators (50), which are preferably arranged and/or interconnected in parallel such that the driving forces of the piezoelectric bending actuators (50), which can be accomplished by electric actuation, will add up in magnitude.

5. The piezoelectric drive (1) according to one of the preceding claims, **characterized in that** the piezoelectric drive unit (5) comprises two bending actuators (50), which are coupled to each other such that, when electrically actuated, at least one of the bending actuators (50) or both bending actuators (50) curves/curve concavely towards the respective other bending actuator (50), the bending actuators (50) having preferably an identical structural design and being, at least sectionwise, coupled to each other circumferentially, preferably on sides facing away from each other, so that they are deformable symmetrically to each other by electric actuation, so as to generate bending deflections in opposite directions.

6. The piezoelectric drive (1) according to one of the preceding claims, **characterized in that** the piezoelectric drive unit (5) is connected to the housing (2) and/or the elastic membrane (4), preferably fixedly, preferably centrally and particularly preferred by a material bond, e.g. by adhesive bonding, welding, soldering, or in a form fit manner, e.g. by at least one spacer ring.

7. The piezoelectric drive (1) according to one of the preceding claims, **characterized in that** the elastic membrane (4) is connected to the housing (2) such that a hermetic seal is formed, preferably circumferentially, particularly preferred along a line closed in itself and arranged in a plane.

8. The piezoelectric drive (1) according to one of the preceding claims, **characterized in that** an inner side of the chamber (3) is provided with a coating, preferably made of plastic, preferably PTFE.

9. The piezoelectric drive (1) according to one of the preceding claims, **characterized in that** the housing (2) comprises a hermetically sealed line passage for routing connections or connection lines (50x, 50y, 50x) of the piezoelectric drive unit (5) therethrough, the line passage being preferably made of glass.

10. The piezoelectric drive (1) according to one of the preceding claims, **characterized in that** the housing (2) comprises a plane flange (21) and a circumferentially extending rim (22) rising from an upper surface of the flange (21), the chamber (3) being, at least sectionwise, defined by the upper surface of the flange (21) and/or an inner side of the rim (22).

11. The piezoelectric drive (1) according to one of the preceding claims, **characterized in that** the piezoelectric drive unit (5) is adapted to be coupled to or is coupled, preferably in a form fit manner, to a drive element (8) arranged outside the chamber (3), the drive element (8) being preferably subjected to the maximum bending deflection of the bending actuator (50).

12. The piezoelectric drive (1) according to one of the preceding claims, **characterized in that** the piezoelectric drive unit (5) comprises two or more bending actuators (50) generating, when electrically actuated, bending deflections in the same direction, wherein preferably two respective bending actuators (50) are arranged adjacent to each other such that, when electrically actuated, one of the bending actuators (50) deforms concavely and one of the bending actuators deforms convexly to the respective other bending actuator (50), the bending actuators (50) having preferably an identical structural design and/or being, at least sectionwise, coupled in planar contact with each other.

13. The piezoelectric drive (1) according to one of the preceding claims, **characterized in that** the maximum bending deflection (B) of the piezoelectric drive unit (5) lies, in relation to the dimension (H) of the piezoelectric drive (1) in the direction of the bending deflection (B), in a range of 10 % to 30 %, preferably in a range of 15 % to 25 %.

14. The piezoelectric drive (1) according to one of the preceding claims, **characterized in that** the dimension (H) of the piezoelectric drive (1) in the direction of the bending deflection (B) lies in a range of 1.5 mm to 20 mm, preferably in a range of 2 mm to 15 mm, preferably in a range of 5 mm to 10 mm.

15. The piezoelectric drive (1) according to one of the preceding claims, **characterized in that** the piezoelectric drive unit (5) comprises two or more piezoelectric bending actuators (50) each generating, when electrically actuated, a bending deflection transversely to the same membrane (4) or transversely to a such a membrane (4) of their own or transversely to various such membranes (4), the various bending actuators (50) generating preferably bending deflections in different, preferably parallel and/or opposite directions.

## Revendications

1. Entraînement piézoélectrique (1), en particulier destiné à une utilisation dans un environnement humide, comprenant un boîtier (2) avec une chambre (3) fermée hermétiquement par une membrane élastique (4) en métal, dans lequel une unité d'entraînement piézoélectrique (5) est agencée dans la chambre (3) hermétiquement fermée et est déformable de manière piézoélectrique par commande électrique afin d'entraîner un élément d'entraînement (8), et l'unité d'entraînement piézoélectrique (5) présente au moins un actionneur de flexion piézoélectrique (50) qui génère une déviation par flexion transversalement par rapport à la membrane élastique (4) lors d'une commande électrique, **caractérisé en ce que** le boîtier (2) est en métal et la membrane élastique (4) est reliée au boîtier (2) par brasage ou soudage.

2. Entraînement piézoélectrique (1) selon la revendication 1, **caractérisé en ce que** l'actionneur de flexion (50) présente une géométrie circulaire, annulaire ou rectangulaire, dans lequel l'actionneur de flexion (50) est de manière préférée plat dans un état initial non formé et est orienté de manière préférée exactement ou essentiellement parallèle à la membrane élastique (4) et/ou génère une déviation par flexion exactement ou essentiellement perpendiculairement à la membrane élastique (4) lors d'une commande électrique.

3. Entraînement piézoélectrique (1) selon l'une quelconque des revendications précédentes, **caractérisé en ce que** l'unité d'entraînement piézoélectrique (5) présente deux ou plus de deux actionneurs de flexion piézoélectriques (50) de manière préférée agencés et/ou connectés en série de telle manière que les déviations par flexion, pouvant être obtenues par commande électrique, des actionneurs de flexion piézoélectriques (50) s'additionnent les unes aux autres en termes de quantité.

4. Entraînement piézoélectrique (1) selon l'une quelconque des revendications précédentes, **caractérisé en ce que** l'unité d'entraînement piézoélectrique (5) présente deux ou plus de deux actionneurs de flexion piézoélectriques (50) de manière préférée agencés et/ou connectés en parallèle de telle manière que les forces d'entraînement, pouvant être obtenues par commande électrique, des actionneurs de flexion piézoélectriques (50) s'additionnent les unes aux autres en termes de quantité.

5. Entraînement piézoélectrique (1) selon l'une quelconque des revendications précédentes, **caractérisé en ce que** l'unité d'entraînement piézoélectrique (5) présente deux actionneurs de flexion (50) couplés l'un à l'autre de telle manière qu'au moins un des actionneurs de flexion (50) ou les deux actionneurs de flexion (50) est/sont courbé(s) de manière concave par rapport à respectivement l'autre actionneur de flexion (50) lors d'une commande électrique, dans lequel les actionneurs de flexion (50) sont de manière préférée réalisés de manière identique et sont couplés les uns aux autres circonférentiellement au moins par sections, de manière préférée au niveau de faces détournées les unes des autres, de sorte qu'ils peuvent être déformés symétriquement l'un par rapport à l'autre par commande électrique afin de générer des déviations par flexion dans des directions opposées.

6. Entraînement piézoélectrique (1) selon l'une quelconque des revendications précédentes, **caractérisé en ce que** l'unité d'entraînement piézoélectrique (5) est reliée au boîtier (2) et/ou à la membrane élastique (4), de manière préférée de manière fixe, de manière préférée au centre, et de manière particulièrement préférée par complémentarité de matière, par exemple par collage, soudage, brasage, ou par complémentarité de forme, par exemple grâce à au moins une bague d'espacement.

7. Entraînement piézoélectrique (1) selon l'une quelconque des revendications précédentes, **caractérisé en ce que** la membrane élastique (4) est reliée au boîtier (2) avec formation d'un joint hermétique, de manière préférée du coté circonférentiel, en particulier de manière préférée le long d'une ligne refermée et agencée dans un plan.

8. Entraînement piézoélectrique (1) selon l'une quelconque des revendications précédentes, **caractérisé en ce qu'**un intérieur de la chambre (3) est muni d'un revêtement, de manière préférée en plastique, de manière préférée en PTFE.

9. Entraînement piézoélectrique (1) selon l'une quelconque des revendications précédentes, **caractérisé en ce que** le boîtier (2) présente un passage de ligne hermétiquement fermé, de manière préférée en verre, permettant de faire passer des raccordements ou des lignes de raccordement (50x, 50y, 50z) de l'unité d'entraînement piézoélectrique (5).

10. Entraînement piézoélectrique (1) selon l'une quelconque des revendications précédentes, **caractérisé en ce que** le boîtier (2) présente une bride plate (21) et un bord circonférentiel (22) s'élevant à partir d'un côté supérieur de la bride (21), dans lequel la chambre (3) est définie au moins par sections grâce au côté supérieur de la bride (21) et/ou à un côté intérieur du bord (22).

11. Entraînement piézoélectrique (1) selon l'une quelconque des revendications précédentes, **caractérisé en ce que** l'unité d'entraînement piézoélectrique (5) peut être couplée ou est couplée, de manière préférée par complémentarité de forme, à un élément d'entraînement (8) agencé à l'extérieur de la chambre (3), dans lequel l'élément d'entraînement (8) subit de manière préférée une déviation de flexion maximale de l'actionneur de flexion (50).

12. Entraînement piézoélectrique (1) selon l'une quelconque des revendications précédentes, **caractérisé en ce que** l'unité d'entraînement piézoélectrique (5) présente au moins deux actionneurs de flexion (50) générant des déviations de flexion dans la même direction par commande électrique, dans lequel de manière préférée respectivement deux actionneurs de flexion (50) sont agencés l'un à côté de l'autre de telle manière que, lors d'une commande électrique, l'un des actionneurs de flexion (50) se déforme de manière concave et l'un des actionneurs de flexion se déforme de manière convexe par rapport à respectivement l'autre actionneur de flexion (50), dans lequel les actionneurs de flexion (50) sont de manière préférée réalisés de manière identique et/ou sont couplés à plat les uns aux autres au moins par sections.

13. Entraînement piézoélectrique (1) selon l'une quelconque des revendications précédentes, **caractérisé en ce que** la déviation de flexion (B) maximale de l'unité d'entraînement piézoélectrique (5) se situe dans la plage comprise entre 10 % et 30 %, de manière préférée dans la plage comprise entre 15 % et 25 %, par rapport à la dimension (H) de l'entraînement piézoélectrique (1) dans la direction de la déviation de flexion (B).

14. Entraînement piézoélectrique (1) selon l'une quelconque des revendications précédentes, **caractérisé en ce que** la dimension (H) de l'entraînement piézoélectrique (1) dans la direction de la déviation de flexion (B) se situe dans la plage comprise entre 1,5 mm et 20 mm, de manière préférée dans la plage comprise entre 2 mm et 15 mm, de manière préférée dans la plage comprise entre 5 mm et 10 mm.

15. Entraînement piézoélectrique (1) selon l'une quelconque des revendications précédentes, **caractérisé en ce que** l'unité d'entraînement piézoélectrique (5) présente deux ou plus de deux actionneurs de flexion piézoélectriques (50) qui génèrent respectivement une déviation de flexion transversalement par rapport à la même membrane (4) ou transversalement par rapport à une membrane (4) de ce type ou transversalement par rapport à diverses membranes (4) de ce type lors d'une commande électrique, dans lequel les différents actionneurs de flexion (50) génèrent de manière préférée des déviations de flexion dans des directions différentes, de manière préférée parallèles et/ou opposées.
